# FASCICULE DE BREVET EUROPEEN

(11) **EP 0 592 285 B1**
(45) Date de publication et mention de la délivrance du brevet: **25.06.1997**
(21) Numéro de dépôt: 93402390.4
(22) Date de dépôt: 30.09.1993
(51) Int. Cl.: C25D 5/02

(54) **Dispositif de dépôt électrolytique d'un métal sur un substrat souple faiblement conducteur, procédé de dépôt électrolytique et produit obtenu par ce procédé**
Verfahren und Vorrichtung zur elektrolytischen Beschichtung eines Schwach leitenden biegsamen Substrates und so hergestelltes Produkt
Process and apparatus for electroplating a metal onto a flexible poor conducteur substrate and product obtained by this process

(30) Priorité: 05.10.1992 FR 9211766
(43) Date de publication de la demande: 13.04.1994
(73) Titulaire: COMMISSARIAT A L'ENERGIE ATOMIQUE, 75015 Paris Cédex 15 (FR)
(72) Inventeur: Jolly, Renaud, F-38000 Grenoble (FR); Legrand, Jacques, F-38100 Grenoble (FR); Petrescu, Cornélia, F-38100 Grenoble (FR)
(74) Mandataire: Dubois-Chabert, Guy

(56) Documents cités:
- US-A- 3 723 283
- US-A- 4 409 924

## Description

La présente invention concerne un dispositif de dépôt électrolytique d'un métal sur un substrat souple faiblement conducteur, ainsi qu'un procédé de dépôt électrolytique et un produit obtenu par ce procédé. Le substrat souple faiblement conducteur peut être par exemple un textile ou une feuille de papier imprégné d'un matériau conducteur, comme par exemple du noir de carbone ou un polymère conducteur. Par le terme dépôt de métal, on comprend également le dépôt d'alliages.

L'invention s'applique notamment à la réalisation de circuits métalliques de formes variées sur des textiles faiblement conducteurs (c'est-à-dire dont la résistance par carré peut atteindre 10 000 Ohms). Ainsi, la réalisation de circuits de cuivre ou de nickel sur un textile imprégné d'un polymère conducteur électronique permet de réaliser des éléments chauffants souples. Ceux-ci sont ensuite utilisés dans la fabrication de gants chauffants, de sièges de voitures chauffants, ou de panneaux qui sont utilisés dans le bâtiment pour le chauffage des habitations, par exemple.

On connaît déjà d'après l'art antérieur des procédés et des dispositifs permettant de réaliser de tels dépôts métalliques électrolytiques sur des substrats faiblement conducteurs.

JP-A-60 228697 décrit un dispositif permettant de métalliser des substrats semiconducteurs. Le substrat est placé à l'ouverture supérieure d'une cellule de dépôt électrolytique. Sa face arrière est en contact avec une électrode plane qui vient fermer la cellule et former la cathode. L'anode est plongée dans la cellule de dépôt électrolytique et fait face audit substrat. L'application d'un courant électrique aux deux bornes des électrodes permet de réaliser le dépôt.

Ce dispositif présente l'inconvénient de ne pouvoir être utilisé qu'avec un substrat ridige afin que sa face arrière soit maintenue au contact avec la cathode plane et qu'il puisse reposer sur le rebord de la cellule de dépôt électrolytique. Par ailleurs, ce dispositif n'offre pas la possibilité de faire de dépôts de formes variées en laissant par exemple, une partie du substrat non revêtue. Enfin, les dépôts en mode semi-continu ne sont pas réalisables avec ce dispositif, puisqu'il est nécessaire de démonter la cathode à la fin de chaque dépôt pour retirer le substrat recouvert et mettre en place un substrat vierge.

FR-A-2 649 126 décrit un procédé de dépôt électrochimique métallique sur un matériau isolant électrique. Le substrat à revêtir étant isolant, il doit, préalablement au dépôt de métal, être rendu conducteur, par dépôt sur sa surface d'un polymère conducteur électronique. Il est ensuite à peine immergé dans une solution d'un sel du métal à déposer. Une tension importante de plusieurs dizaines de volts est appliquée entre le substrat prétraité servant de cathode et une anode plongeant dans la solution électrolytique. A mesure que le dépôt se fait à l'extrémité du substrat, on introduit celui-ci de plus en plus dans la solution, en même temps que l'on diminue la tension appliquée. Finalement, on maintient le substrat pendant 30 à 45 minutes à une tension de quelques volts jusqu'à obtenir un dépôt satisfaisant.

Ce procédé présente l'inconvénient d'être extrêmement lent et de ne permettre les dépôts métalliques de formes quelconques qu'avec un masquage complexe. Ces deux inconvénients rendent donc impossible un dépôt rapide, en mode semi-continu.

On connaît enfin d'après le document US-A-3 723 283 un dispositif d'électro-déposition permettant d'effectuer des dépôts de forme spécifique sur un tissu ou une bande de matériau. Le tissu se déroule en mode semi-continu, devant divers postes de travail successifs où il subit plusieurs traitements. Ce dispositif comprend deux têtes de dépôt mobiles qui peuvent s'écarter ou se rapprocher pour pincer le tissu sur lequel le dépôt est effectué. L'électrolyte à déposer est amené à travers ces têtes de dépôt.

Toutefois, si l'on souhaite modifier la forme du dépôt effectué, il est nécessaire de changer toute la tête de dépôt.

En conséquence, l'invention a pour but de remédier aux inconvénients précités. A cet effet, l'invention concerne un dispositif de dépôt électrolytique d'un métal, sur un substrat souple faiblement conducteur.

Selon les caractéristiques de l'invention, ce dispositif comprend une cuve d'électrolyse, une première et une deuxième électrodes planes placées dans ladite cuve d'électrolyse et au moins un élément formant masque, placé entre les deux électrodes, ce masque étant réalisé dans un matériau électriquement isolant, comportant au moins une ouverture ayant la forme du dépôt que l'on veut reproduire sur ledit substrat et étant muni de moyens moteurs permettant de le déplacer entre une première position où il est éloigné du substrat à traiter et une deuxième position où il est plaqué sur ledit substrat.

Ce dispositif permet de réaliser un dépôt métallique de forme quelconque par voie électrochimique sur un substrat souple faiblement conducteur dans la masse, (c'est-à-dire un substrat dont la résistance par carré peut atteindre 10 000 Ohms). Ce dépôt est réalisable en un minimum de temps et avec un nombre minimum d'opérations. En effet, il suffit d'appliquer le masque pendant un temps du dépôt relativement bref et de le retirer une fois le dépôt effectué. (Pendant le dépôt, le substrat est pincé entre le masque et la première électrode). En outre, on peut très facilement changer de masque pour en appliquer un nouveau présentant une forme différente.

De façon avantageuse, les dimensions de la première électrode sont égales ou supérieures à celles du masque, prises au niveau de la périphérie de ce masque.

Ainsi, le serrage du masque sur le substrat (ou plus précisément sur l'ensemble substrat-première électrode) garantit une étanchéité suffisante empêchant tout dépôt sur la face du substrat souple dirigée vers la première électrode. On évite ainsi les risques de court-circuit.

L'invention concerne également un procédé de dépôt électrolytique caractérisé en ce qu'il comprend les étapes consistant à :
a) plonger ledit substrat dans une cuve d'électrolyse remplie d'un électrolyte, ce substrat souple, faiblement conducteur étant disposé entre une première et une deuxième électrodes, placées également dans la cuve d'électrolyse, au moins l'une de ces deux électrodes étant réalisée dans le métal que l'on souhaite déposer et constituant une anode,
b) maintenir une face dudit substrat en contact avec ladite première électrode,
c) disposer entre la face opposée dudit substrat et la deuxième électrode, un élément réalisé dans un matériau électriquement isolant et formant un masque, ce masque présentant au moins une ouverture correspondant à la forme du dépôt que l'on veut reproduire sur ledit substrat,
d) déplacer ce masque pour le plaquer contre ladite face opposée du substrat grâce à des moyens moteurs, de façon qu'il n'y ait pas d'électrolyte entre le masque et le substrat,
e) appliquer une faible tension électrique entre la première et la deuxième électrodes, de façon à réaliser le dépôt,
f) soulever le masque grâce auxdits moyens moteurs pour obtenir le substrat recouvert du dépôt,
g) faire défiler le substrat en mode semi-continu entre la première électrode et le masque et répéter les étapes d) à f) sur des portions successives dudit substrat.

Le fait de pouvoir faire défiler la bande en mode semi-continu et de ne pas devoir enlever le substrat à chaque opération de dépôt, permet d'accélérer le procédé de fabrication.

L'invention concerne enfin un produit obtenu par le procédé précité. Ce produit est caractérisé en ce que le substrat comprend un support textile isolant électrique recouvert d'un polymère organique conducteur électronique dopé et en ce que le métal déposé forme au moins deux électrodes, en forme de peigne.

Un autre produit est caractérisé en ce que le substrat est un polymère organique, conducteur électronique dopé et en ce que le métal est déposé sur deux bords latéraux opposés dudit substrat de façon à former une bande continue prolongée vers la partie médiane du substrat par des électrodes.

L'invention sera mieux comprise à la lecture de la description suivante d'un mode de réalisation de l'invention, donné à titre d'exemple illustratif et non limitatif, cette description étant faite en faisant référence aux dessins joints, dans lesquels :
- la figure 1 est une vue en coupe schématique d'un premier mode de réalisation du dispositif de dépôt de l'invention,
- la figure 2 est une vue partielle en perspective éclatée d'un second mode de réalisation du dispositif selon l'invention,
- la figure 3 est un schéma illustrant les diverses étapes du procédé de dépôt électrolytique selon l'invention,
- la figure 4 est une vue en perspective d'un premier produit obtenu par le procédé selon l'invention,
- la figure 5 est une vue en perspective d'un deuxième produit obtenu par le procédé selon l'invention, c'est-à-dire un gant chauffant, et
- la figure 6 est un schéma illustrant un tissu utilisé dans la réalisation de ce gant.

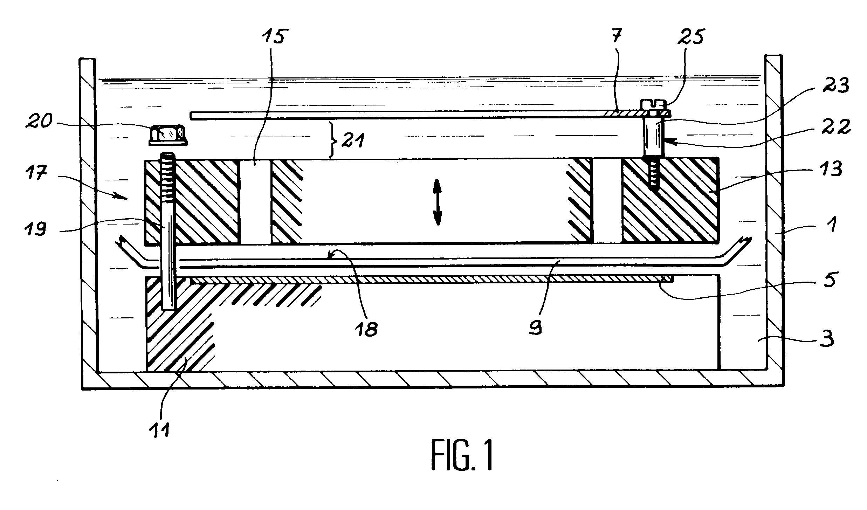

Comme illustré en figure 1, le dispositif de dépôt électrolytique selon l'invention comprend une cuve d'électrolyse 1 contenant un électrolyte 3. De façon classique, une première électrode 5 et une deuxième électrode 7 sont disposées à l'intérieur de la cuve 1. Ces électrodes planes présentent une forme sensiblement rectangulaire. L'électrode 7 jouant le rôle d'anode est réalisée dans le métal que l'on souhaite déposer. A titre d'exemple illustratif, ce métal peut être du cuivre ou du nickel. Le substrat à traiter, référencé 9, est disposé à l'intérieur de la cuve 1 entre les deux électrodes 5 et 7. Ce substrat n'est ici représenté que partiellement afin de simplifier la figure, mais normalement il se présente sous forme d'une bande continue. Comme cela sera décrit en détail ultérieurement, l'électrode 5 repose sur une plaque 11 de matériau isolant.

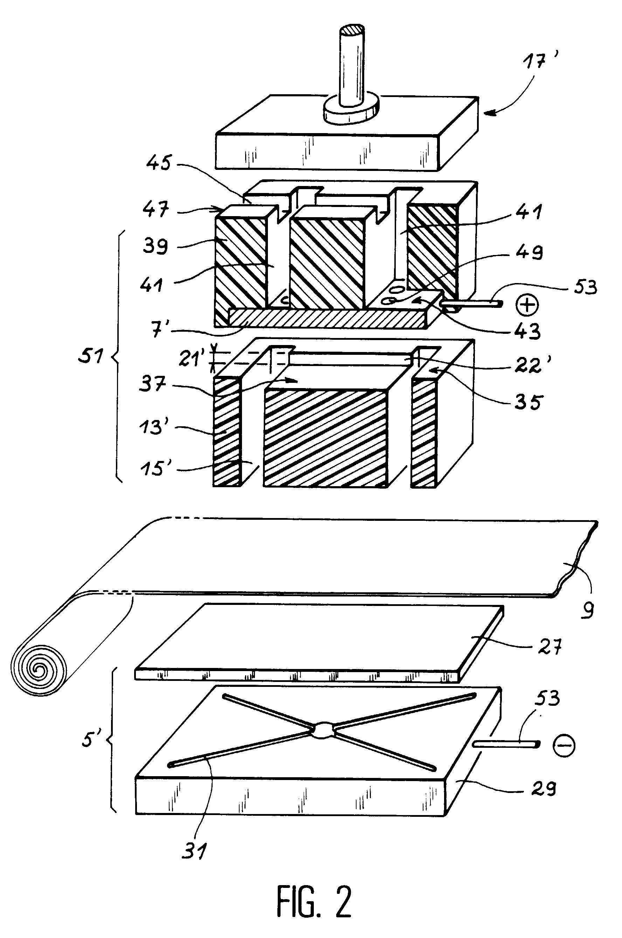

Un élément formant masque 13, réalisé dans un matériau électriquement isolant, est disposé également à l'intérieur de la cuve 1, entre les deux électrodes 5 et 7 et plus précisément entre le substrat 9 et la deuxième électrode 7. Il serait également possible d'utiliser un masque 13 en plusieurs morceaux. De préférence, le matériau isolant utilisé est le polypropylène. Ce masque 13 a la forme d'un bloc rectangulaire, percé d'au moins une ouverture 15 ayant la forme du dépôt que l'on veut reproduire sur le substrat 9. Ce masque apparaît mieux en figure 2. Ce masque 13 permet de réaliser des dépôts de formes variées sur seulement certaines parties du substrat.

Afin de réaliser ces dépôts, ce masque 13 est pressé sur le substrat 9, avec une pression suffisante pour empêcher l'électrolyte 3 présent dans la cuve de venir au contact des parties du substrat 9 que l'on ne souhaite pas revêtir. En d'autres termes, le pressage du masque 13 sur le substrat 9 est tel qu'il assure une étanchéité suffisante pour que les dépôts métalliques ne soient réalisés que sur une face du substrat avec la géométrie et les dimensions désirées. A cet effet, le masque 13 est muni de moyens moteurs 17 permettant de le déplacer entre une première position, (illustrée en figure 1), où il est éloigné du substrat 9 et une deuxième position dans laquelle il est plaqué contre la face supérieure 18 du substrat 9 en appliquant ce substrat contre la première électrode 5. On évite ainsi également qu'un dépôt métallique ne se forme sur la face du substrat placée en regard de la première électrode. Un tel dépôt risquerait en effet d'engendrer des court-circuits dans le produit final.

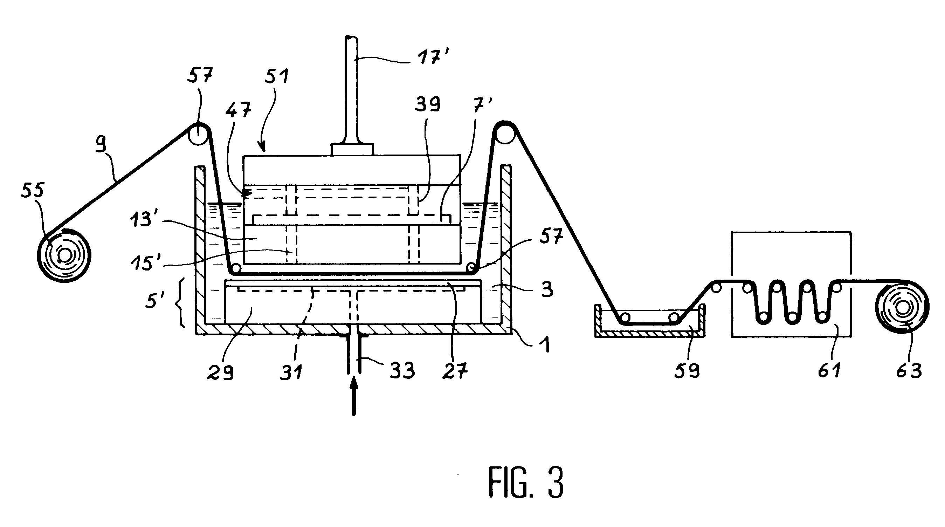

Les moyens moteurs 17 peuvent être constitués par un moyen mécanique, tel qu'une vis 19 et un écrou 20, comme cela est illustré en figure 1, ou un système de ressort (non représenté), ou encore un dispositif pneumatique illustré schématiquement en figure 3. Lorsqu'on utilise des vis 19, on en dispose de préférence six, c'est-à-dire trois de chaque grand côté du masque 13.

La deuxième électrode 7 est fixée sur le masque 13, de façon à ménager avec celui-ci un espace 21 défini par des moyens d'entretoise 22. Ces moyens sont ici constitués par au moins un manchon 23 disposé autour d'au moins une vis 25. De préférence, ces vis 25 et ces manchons 23 sont au nombre de quatre répartis aux quatre coins de l'électrode 7.

Un second mode de réalisation du dispositif de l'invention est illustré en figure 2. Il présente de nombreux points communs avec celui décrit en figure 1 et simplement quelques variantes structurelles. En conséquence, les éléments communs aux deux figures ont conservé les mêmes références et les éléments communs présentant quelques variantes ont conservé la même référence majorée d'un signe prime. Sur cette figure 2, la cuve d'électrolyse 1 n'a pas été représentée à des fins de simplification, mais tous les éléments représentés sur cette figure plongent normalement dans ladite cuve remplie d'électrolyte.

Le substrat 9 se présente sous la forme d'un rouleau comme cela apparaît mieux sur cette figure 2. La première électrode 5' est constituée d'une mince feuille 27 d'un matériau conducteur électrique, tel que de l'acier inoxydable, par exemple, et d'une embase 29. Celle-ci est réalisée dans un matériau électriquement conducteur et présente les mêmes dimensions que la feuille 27. Cette embase 29 comporte sur sa face supérieure des rainures 31 en communication avec une arrivée d'air comprimé 33 illustrée en figure 3 uniquement et permettant de plaquer la feuille 27 contre le substrat 9. Enfin, cette électrode 5' joue, de préférence, le rôle de cathode. De façon avantageuse, les dimensions de l'électrode 5' sont égales ou supérieures à celles du masque 13' prises au niveau de la périphérie de celui-ci. En d'autres termes, l'électrode 5' "déborde" autour du masque 13". Ceci permet d'éviter que l'électrolyte ne pénètre entre le substrat 9 et l'électrode 5' et y forme un dépôt.

Le masque 13', comportant des ouvertures 15', présente une structure assez voisine de celui décrit en figure 1. Toutefois, sa face supérieure 35, c'est-à-dire la face placée en regard de la deuxième électrode 7' est creusée dans sa partie centrale en 37 de façon à définir sur son pourtour un rebord périphérique 22' formant un moyen d'entretoise avec la deuxième électrode 7' disposée au-dessus. L'espace entre la partie creuse 37 et l'électrode 7' est référencée 21'. En outre, la partie creusée 37 permet la libre circulation de l'électrolyte 3 entre plusieurs ouvertures 15' voisines.

La deuxième électrode 7' joue ici le rôle d'une anode, elle est réalisée dans le métal que l'on souhaite déposer. Cette électrode 7' est surmontée d'un bloc support 39 réalisé dans un matériau électriquement isolant, tel que le polypropylène. Cette deuxième électrode 7' est fixée sur ce bloc support 39 par des moyens non représentés en figure 2. Ce bloc support comprend intérieurement au moins une rainure verticale 41 creusée dans la masse jusqu'au niveau de la surface supérieure 43 de l'électrode 7'. Les deux rainures verticales 41 illustrées sur cette figure 3 sont reliées entre elles par au moins une rainure horizontale 45 débouchant à l'extérieur en 47 sur l'une des parois latérales du bloc support 39.

En outre, la deuxième électrode 7' est percée d'au moins un orifice 49 débouchant d'une part à l'intérieur d'une des rainures 41 du masque 13' et d'autre part dans l'une des ouvertures 15'. Ces orifices 49 permettent l'évacuation de l'hydrogène dégagé lors de la réaction d'électrolyse.

Le masque 13', la deuxième électrode 7' et le bloc support 39 sont fixés ensemble et forment un ensemble 51 qu'il est possible de déplacer verticalement grâce à des moyens moteurs 17' dont le rôle a déjà été expliqué lors de la description de la figure 1. Dans ce cas particulier, les moyens moteurs 17' sont constitués par un dispositif de levage pneumatique ou piston, représenté ici schématiquement.

Enfin, deux connexions électriques 53 sont prévues aux deux extrémités respectives de la deuxième électrode 7' et de l'embase 29. Ces connexions 53 sont reliées à un générateur non représenté, elles permettent d'appliquer un courant d'intensité fixée, dans le circuit constitué par la deuxième électrode 7', l'électrolyte 3, le substrat à revêtir 9 et la première électrode 5'.

La figure 3 illustre les diverses étapes du procédé de dépôt électrolytique selon l'invention. Sur cette figure 3, le dispositif de dépôt électrolytique qui a été détaillé sur les figures 1 et 2 est représenté schématiquement et les éléments communs ont conservé les mêmes références.

Le substrat 9 se présente sous forme d'un rouleau initial 55. Une longueur de ce substrat correspondant à la longueur de l'électrode 5' est déroulée entre cette électrode 5' et le masque 13', à l'intérieur de la cuve d'électrolyse 1. Afin de traverser correctement la cuve d'électrolyse 1, ce substrat 9 passe sur quatre rouleaux de guidage 57.

L'ensemble 51 (formé par le masque 13', l'électrode 7' et le bloc support 39) est descendu au contact du substrat 9 par les moyens moteurs 17'. En outre, la feuille 27 de la première électrode 5' vient se plaquer contre le substrat 9 grâce à l'injection d'air comprimé, réalisée dans l'orifice 33. Seules les ouvertures 15' ménagées dans le masque 13' et fermées à une extrémité par le substrat 9 et à l'autre par l'électrode 7' sont remplies d'électrolyte 3. Le niveau d'électrolyte 3 est contrôlé de façon qu'il recouvre complétement l'électrode 7' en laissant émerger la partie supérieure du bloc support 39 et donc l'extrémité 47 de la rainure 45 permettant le dégazage.

On applique aux bornes des deux électrodes une faible tension électrique, pendant un temps fixé. Ceci permet de réaliser des dépôts sur des substrats 9 dont le résistance par carré atteint 10 000 Ohms.

Cette technique permet de diminuer le temps de dépôt. En effet, du fait que le substrat 9 est maintenu en contact sur toute sa surface avec la feuille 27 reposant elle-même sur l'embase 29, on diminue ainsi la résistance électrique entre l'amenée de courant et la zone où se fera le dépôt. Cette résistance correspond à l'épaisseur du substrat 9, soit le plus souvent à une résistance assez faible. Par ailleurs, la résistance électrique entre l'amenée de courant (l'électrode 5') et la zone à revêtir sera identique en tout point, ce qui évite de faire varier la tension d'alimentation pendant la phase de dépôt et qui garantit une bonne homogénéité du dépôt final.

Le dépôt s'opère ainsi uniquement sur les parties du substrat 9 en contact avec l'électrolyte 3. Au bout du temps fixé, l'ensemble 51 est relevé par les moyens moteurs 17'. On déroule alors le substrat 9 de façon qu'une nouvelle longueur de substrat à traiter soit placée entre le masque 13 et l'électrode 5'. En outre, la partie du substrat ayant reçu le dépôt électrolytique subit alors une étape de rinçage dans un bain d'eau 59, tandis que la longueur de substrat vierge 9 subit de nouveau le traitement décrit précédemment. Lorsque le substrat 9 avance de nouveau d'une longueur, la partie rincée dans le bain 59 pénètre dans un dispositif de séchage 61 où elle est alors séchée avant d'être enroulée sur le rouleau final 63.

On donne ci-après plusieurs exemples de réalisation de dépôts électrolytiques selon l'invention.

### Exemple 1 : Dépôt électrolytique de cuivre sur un substrat polyester imprégné de polymère conducteur.

Le substrat 9 à traiter présente une résistance par carré de 10 Ohms. L'électrode 5, 5' est constituée d'une plaque de cuivre. Le masque 13, 13' présente deux ouvertures 15, 15' rectangulaires d'une surface de 3 cm² chacune. L'électrolyte 3 contenu dans la cuve présente la composition suivante :
- 875 g H₂O,
- 125 g de CuSO₄, 5H₂O,
- 10 g de H₂SO₄.

La deuxième électrode 7, 7' est également réalisée en cuivre, elle forme une anode. Elle est espacée du masque 13, 13' d'une distance de 15 mm, (entretoise). On fait passer un courant de 1 ampère pendant 5 minutes dans le circuit, puis on coupe l'alimentation électrique. Après avoir soulevé l'ensemble 51, on obtient sur le substrat 9 un dépôt adhérent de cuivre de 200 mg et de la même dimension que les deux ouvertures (15, 15') pratiquées dans le masque.

### Exemple 2

Les conditions opératoires sont identiques à celles de l'exemple 1, sauf que l'on fait passer un courant de 0,5 A pendant une durée de 10 minutes. On obtient un dépôt adhérent de cuivre de 200 mg.

### Exemple 3

On utilise les mêmes conditions opératoires que dans l'exemple 1, sauf que l'on fait passer un courant de 2 A pendant une durée de 4 minutes. On obtient un dépôt adhérent de cuivre de 315 mg.

### Exemple 4

Les conditions opératoires sont les mêmes que dans l'exemple 1, sauf que la cathode 5, 5' est réalisée en acier inoxydable. On fait passer un courant de 2 A pendant une durée de 6 minutes. On obtient un dépôt adhérent en cuivre de 450 mg.

### Exemple 5

Les conditions opératoires sont les mêmes que dans l'exemple 1. Le substrat 9 est un non tissé imprégné de noir de carbone et présentant une résistance par carré de 2500 Ohms. On fait passer un courant de 0,6 A pendant une durée de 6 minutes. On obtient un dépôt adhérent de cuivre de 150 mg.

### Exemple 6 : Dépôt électrolytique de nickel sur un substrat textile en polyester revêtu de polymère conducteur.

Le dispositif utilisé est identique à celui de l'exemple 1, sauf que l'électrode 5, 5' est réalisée en acier inoxydable. L'électrolyte 3 présente la composition suivante :
- 670 g H₂O,
- 250 g de NiSO₄(7H₂O),
- 40 g de NiCl₂,
- 40 g de H₃BO₃.

Pendant toute la durée de l'électrolyse, l'électrolyte 3 précité est chauffé à une température de 60°C. On fait passer un courant de 1 A pendant une durée de 35 minutes. On obtient un dépôt de nickel de 20 mg, ayant la même forme et les mêmes dimensions que les deux ouvertures (15, 15') pratiquées dans le masque précité.

### Exemple 7 : Dépôt électrolytique de cuivre sur un substrat textile recouvert d'un polymère organique conducélectronique, dopé par un anion

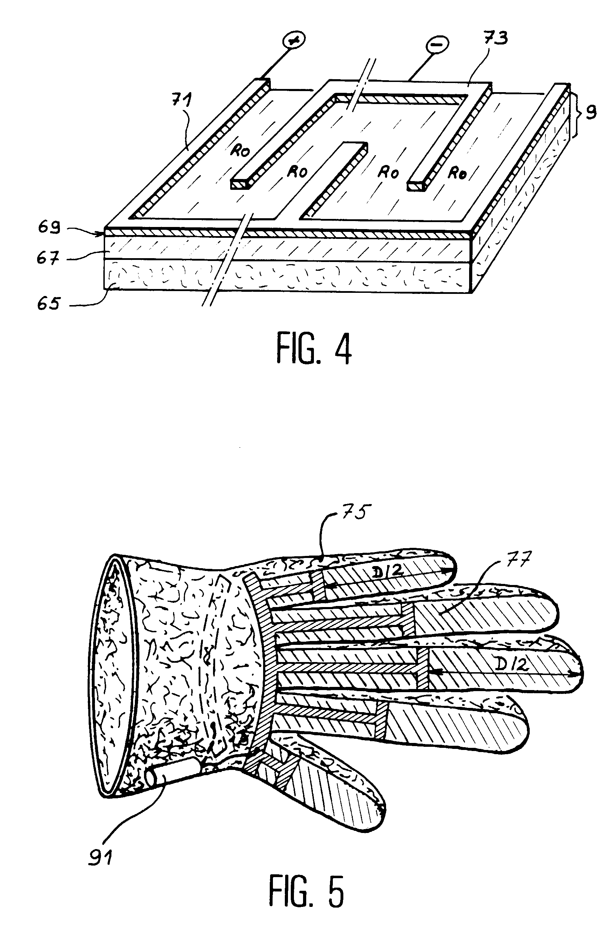

Comme illustré en figure 4, le substrat 9 à traiter se présente sous la forme d'un support textile 65 isolant électrique, recouvert d'une couche 67 de polymère organique conducteur électronique, dopé par un anion. Ce polymère est formé par un dépôt multicouche de polypyrrole présentant une résistance par carré de 10 ohms.

Afin d'obtenir un tissu chauffant répondant aux spécifications électrique et thermique exigées, il est nécessaire de déposer une couche de cuivre 69 pour former des électrodes 71 et 73. Ces deux électrodes 71 et 73 peuvent être connectées respectivement à la borne positive et à la borne négative d'une source d'alimentation électrique qui peut être le secteur ou une batterie selon l'application envisagée.

Les deux électrodes 71 et 73 doivent être réalisées sous forme de deux peignes disposés en regard l'un de l'autre, les dents de l'électrode 71 étant imbriquées dans les dents de l'électrode 73, de façon à adapter la résistance finale du tissu chaufffant, en fonction des applications ultérieures visées. Ainsi, ces dents sont arrangées entre elles de façon à définir des éléments résistants de même surface et de même valeurs de résistance R₀ (égale ici à 5 ohms).

En conséquence, le masque 13, 13' est muni d'ouvertures 15, 15' dont la forme correspond aux peignes que l'on veut obtenir. Les conditions opératoires sont identiques à celles de l'exemple 1, sauf que l'on fait passer un courant de 0,6 A pendant une durée de 6 minutes. On obtient ainsi un dépôt de cuivre adhérent en forme de peigne.

On peut ainsi réaliser par exemple une couverture chauffante de 1x2 m, alimentée sous une tension de 24 volts maximum et dissipant une puissance de 150 W/m².

### Exemple 8 : Dépôt électrolytique de cuivre sur un support textile recouvert d'un polymère organique conducélectronique dopé, en vue de la fabrication d'un gant

Dans cet exemple, on a cherché à réaliser un gant chauffant, tel que celui illustré en figure 5. Le gant 75 est réalisé dans un textile isolant électrique tel que du coton ou de la laine.

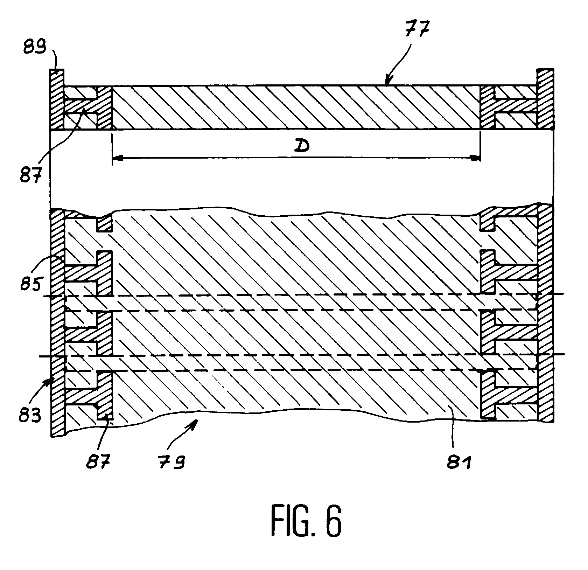

Des éléments chauffants 77 sont fabriqués par le procédé de dépôt selon l'invention et rapportés ultérieurement sur le gant. Ces éléments chauffants sont fabriqués à partir d'un tissu 79, tel que celui illustré en figure 6. Ce tissu comprend un substrat 81 en polymère organique conducteur électronique dopé, sur lequel on effectue des dépôts de cuivre 83 pour former des électrodes. Chaque dépôt est réalisé sur les deux bords latéraux opposés du tissu 79, sous la forme d'une bande continue 85 parallèle à l'axe longitudinal dudit tissu et prolongée vers la partie médiane du tissu 79 par des électrodes en T 87 perpendiculaires à cette bande 85. Le dépôt est effectué par le procédé selon l'invention. Le masque 13, 13' présente donc une forme spécifique adaptée à ce type de dépôt.

Les conditions opératoires sont identiques à celles de l'exemple 1, sauf que l'on fait passer un courant de 1,2 A pendant 6 minutes.

Le tissu 79 est ensuite découpé selon les pointillés de la figure 6, de façon à obtenir des éléments chauffants unitaires 77, tel que celui représenté dans la partie supérieure de la figure 6. Ce découpage est réalisé de façon à former des languettes latérales 89 pour chaque électrode 87. Chaque élément chauffant 77 est alors plié en deux et cousu sur un doigt du gant, en prenant soin que chaque languette latérale 89 d'un élément 77 recouvre la partie de bande 85 de l'élément chauffant jointif. On assure ainsi la continuité du circuit électrique et le branchement en parallèle des éléments chauffants 77. L'alimentation électrique de ces éléments 77 est réalisée à l'aide d'une pile ou d'une batterie 91.

Pour avoir une bonne homogénéité du chauffage de chaque doigt, il est nécessaire que la distance D entre l'extrémité de deux électrodes 87 soit identique pour chaque doigt du gant. On ajuste donc la longueur de chaque électrode 87 en conséquence, lors de la fabrication du tissu (voir figure 5).

On a ainsi pu obtenir un gant chauffant permettant de porter la température de l'extrémité des doigts à une valeur supérieure à 28°C pour une température extérieure de 0°C. On notera que la forme en T de chaque électrode 87 (c'est-à-dire en son milieu) permet à l'utilisateur de plier les doigts plus facilement.

## Revendications

1. Dispositif de dépôt électrolytique d'un métal, sur un substrat souple faiblement conducteur (9, 81), caractérisé en ce qu'il comprend une cuve d'électrolyse (1), une première et une deuxième électrodes planes (5, 5' ; 7, 7'), placées dans ladite cuve d'électrolyse et au moins un élément (13, 13') formant masque, placé entre les deux électrodes (5, 5' ; 7, 7'), ce masque (13, 13') étant réalisé dans un matériau électriquement isolant, comportant au moins une ouverture (15, 15') ayant la forme du dépôt que l'on veut reproduire sur ledit substrat (9, 81) et étant muni de moyens moteurs (17, 17') permettant de le déplacer entre une première position où il est éloigné du substrat à traiter (9, 81) et une deuxième position où il est plaqué sur ledit substrat (9, 81).

2. Dispositif de dépôt électrolytique selon la revendication 1, caractérisé en ce que la deuxième électrode (7, 7') est fixée sur le masque (13, 13') de façon à ménager avec celui-ci un espace (21, 21') défini par des moyens d'entretoise (22, 22').

3. Dispositif de dépôt électrolytique selon la revendication 2, caractérisé en ce que les moyens d'entretoise (22) sont formés par au moins un manchon (23) disposé autour d'au moins une vis (25) fixant la deuxième électrode (7) sur le masque (13).

4. Dispositif de dépôt électrolytique selon la revendication 2, caractérisé en ce que la face (35) du masque (13) placée en regard de la deuxième électrode (7') est creusée dans sa partie centrale (37) de façon à définir sur son pourtour un rebord (22') formant lesdits moyens d'entretoise.

5. Dispositif de dépôt électrolytique selon la revendication 1, caractérisé en ce que la deuxième électrode (7') est fixée sous un bloc support (39) réalisé dans un matériau électriquement isolant et en ce que ce bloc support (39) comprend au moins une rainure (41, 45) creusée dans sa masse et reliant la face supérieure (43) de la deuxième électrode (7') à l'extérieur, ladite deuxième électrode (7') comprenant au moins un orifice (49) débouchant dans l'une desdites rainures (41) et dans l'une desdites ouvertures (15') du masque (13'), de façon à définir un circuit d'évacuation de l'hydrogène formé au cours de la réaction d'électrolyse.

6. Dispositif de dépôt électrolytique selon la revendication 1, caractérisé en ce que les moyens moteurs (17) sont formés par au moins une vis (19) et au moins un boulon (20).

7. Dispositif de dépôt électrolytique selon la revendication 1, caractérisé en ce que les moyens moteurs (17') sont formés par des vérins pneumatiques.

8. Dispositif de dépôt électrolytique selon la revendication 1, caractérisé en ce que la première électrode (5') est formée d'une feuille (27) de matériau conducteur d'électricité et d'une embase (29) munie de moyens à air comprimé (31, 33) permettant de plaquer ladite feuille (27) contre le substrat (9, 81).

9. Dispositif de dépôt électrolytique selon la revendication 1 ou 8, caractérisé en ce que les dimensions de la première électrode (5') sont égales ou supérieures à celles du masque (13') prises au niveau de la périphérie de ce masque.

10. Dispositif de dépôt électrolytique selon la revendication 1, caractérisé en ce que la première électrode (5, 5') est une cathode et la deuxième (7, 7') une anode réalisée en cuivre ou nickel.

11. Procédé de dépôt électrolytique d'un métal sur un substrat souple, faiblement conducteur (9, 81), se présentant sous forme d'une bande continue, caractérisé en ce qu'il comprend les étapes consistant à :
a) plonger ledit substrat (9, 81) dans une cuve d'électrolyse (1) remplie d'un électrolyte (3), ce substrat souple, faiblement conducteur (9, 81) étant disposé entre une première et une deuxième électrodes (5, 5' ; 7, 7') placées également dans la cuve d'électrolyse, au moins l'une de ces deux électrodes étant réalisée dans le métal que l'on souhaite déposer et constituant une anode,
b) maintenir une face dudit substrat (9, 81) en contact avec ladite première électrode (5, 5'),
c) disposer entre la face opposée (18) dudit substrat (9, 81) et la deuxième électrode (7, 7'), un élément (13, 13') réalisé dans un matériau électriquement isolant et formant un masque, ce masque présentant au moins une ouverture (15, 15') correspondant à la forme du dépôt que l'on veut reproduire sur ledit substrat,
d) déplacer ce masque (13, 13') pour le plaquer contre ladite face opposée (18) du substrat (9, 81), grâce à des moyens moteurs (17, 17'), de façon qu'il n'y ait pas d'électrolyte (3) entre le masque (13, 13') et le substrat (9, 81),
e) appliquer une faible tension électrique entre la première (5, 5') et la deuxième électrodes (7, 7'), de façon à réaliser le dépôt,
f) soulever le masque (13, 13') grâce auxdits moyens moteurs (17, 17') pour obtenir le substrat (9, 81) recouvert du dépôt,
g) faire défiler le substrat souple, faiblement conducteur (9, 81) en mode semi-continu entre la première électrode (5, 5') et le masque (13, 13') et répéter les étapes d) à f) sur des portions successives dudit substrat (9, 81).

12. Produit obtenu par le procédé selon la revendication 11, caractérisé en ce que le substrat (9) comprend un support textile (65) isolant électrique recouvert d'un polymère organique conducteur électronique dopé (67) et en ce que le métal déposé (69) forme au moins deux électrodes (71, 73).

13. Produit selon la revendication 12, caractérisé en ce que les deux électrodes (71, 73) ont chacune la forme d'un peigne et sont disposées en regard l'une de l'autre de façon que les dents de l'électrode (71) soient imbriquées dans les dents de l'électrode (73).

14. Produit obtenu par le procédé selon la revendication 11, caractérisé en ce que le substrat (81) est un polymère organique, conducteur électronique dopé et en ce que le métal est déposé sur deux bords latéraux opposés dudit substrat de façon à former une bande continue (85) prolongée vers la partie médiane du substrat (81) par des électrodes (87).

15. Produit selon la revendication 14, destiné à former un élément chauffant (77) utilisé dans la fabrication d'un gant, caractérisé en ce que le métal est déposé sur chacun des bords opposés dudit substrat (81) de façon à former une électrode (87) munie d'une bande de connexion électrique (85) et d'une languette latérale (89).

## Patentansprüche

1. Vorrichtung zur elektrolytischen Beschichtung eines Metalls auf einem schwach leitenden, biegsamen Substrat (9, 81), **dadurch gekennzeichnet**,
daß es eine Elektrolysewanne (1) umfaßt, eine erste und eine zweite flache Elektrode (5, 5'; 7, 7'), angeordnet in besagter Elektrolysewanne, und wenigstens ein eine Maske bildendes Element (13, 13'), angeordnet zwischen den beiden Elektroden (5, 5'; 7, 7'), wobei diese Maske (13, 13'), hergestellt aus einem elektrisch isolierenden Material, wenigstens eine öffnung (15, 15') mit der Form der Beschichtung aufweist, die man auf dem Substrat (9, 81) reproduzieren will, und versehen ist mit Verstelleinrichtungen (17, 17'), die ermöglichen, sie zu verschieben zwischen einer ersten Stellung, in der sie von dem zu behandelnden Substrat (9, 81) entfernt ist, und einer zweiten Stellung, in der sie auf das zu behandelnde Substrat (9, 81) gepreßt wird.

2. Vorrichtung zur elektrolytischen Beschichtung nach Anspruch 1, dadurch gekennzeichnet, daß die zweite Elektrode (7, 7') auf der Maske (13, 13') derart befestigt ist, daß sie mit dieser zusammen einen Raum (21, 21') ausspart, definiert durch Abstandseinrichtungen (22, 22').

3. Vorrichtung zur elektrolytischen Beschichtung nach Anspruch 2, dadurch gekennzeichnet, daß die Abstandseinrichtungen (22) gebildet werden durch wenigstens eine Hülse (23), angebracht um wenigstens eine Schraube (25), die die zweite Elektrode (7) auf der Maske (13) befestigt.

4. Vorrichtung zur elektrolytischen Beschichtung nach Anspruch 2, dadurch gekennzeichnet, daß die Seite (35) der Maske (13'), der zweiten Maske (7') gegenüberstehend, in ihrem zentralen Teil (37) derart ausgetieft ist, daß sie an ihrem äußeren Umfang einen Rand (22') aufweist, der die genannten Abstandseinrichtungen bildet.

5. Vorrichtung zur elektrolytischen Beschichtung nach Anspruch 1, dadurch gekennzeichnet, daß die zweite Elektrode (7') unter einem Trägerblock (39) befestigt ist, hergestellt aus einem elektrisch isolierenden Material, und dadurch, daß dieser Trägerblock (39) wenigstens einen in seiner Masse ausgebildeten Schlitz (41, 45) umfaßt, der die Oberseite (43) der zweiten Elektrode (7') mit der Außenseite verbindet, wobei diese zweite Elektrode (7') wenigstens eine öffnung (49) umfaßt, die in einem der besagten Schlitze (41) und in einer der besagten Öffnungen (15') der Maske (13') mündet, derart einen Entleerungskreis für den Wasserstoff bildend, der sich im Laufe der Elektrolysereaktion bildet.

6. Vorrichtung zur elektrolytischen Beschichtung nach Anspruch 1, dadurch gekennzeichnet, daß die Verstelleinrichtungen (17) durch wenigstens eine Schraube (19) und wenigstens eine Mutter (20) gebildet werden.

7. Vorrichtung zur elektrolytischen Beschichtung nach Anspruch 1, dadurch gekennzeichnet, daß die Verstelleinrichtungen (17) durch Pneumatikzylinder gebildet werden.

8. Vorrichtung zur elektrolytischen Beschichtung nach Anspruch 1, dadurch gekennzeichnet, daß die erste Elektrode (5') gebildet wird durch eine Folie (27) aus elektrisch leitendem Material und aus einem Sockel (29), versehen mit Drucklufteinrichtungen (31, 33), die ermöglichen, die Folie (27) gegen das Substrat (8, 81) zu pressen.

9. Vorrichtung zur elektrolytischen Beschichtung nach Anspruch 1 oder 8, dadurch gekennzeichnet, daß die Abmessungen der ersten Elektrode (5') gleich oder größer sind als die der Maske (13'), gemessen in Höhe des Rands dieser Maske.

10. Vorrichtung zur elektrolytischen Beschichtung nach Anspruch 1, dadurch gekennzeichnet, daß die erste Elektrode (5, 5') eine Kathode ist und die zweite Elektrode (7, 7') eine Anode ist, hergestellt aus Kupfer oder Nickel.

11. Verfahren zur elektrolytischen Beschichtung eines Metalls auf einem schwach leitenden, biegsamen Substrat (9, 81), das die Form eines kontinuierlichen Streifens aufweist,
**dadurch gekennzeichnet,** daß es die folgenden Schritte umfaßt:
a) Eintauchen dieses Substrats (9, 81) in eine Elektrolysewanne (1), gefüllt mit einem Elektrolyt (3), wobei dieses schwach leitende, biegsame Substrat angeordnet ist zwischen einer ersten und einer zweiten Elektrode (5, 5'; 7, 7'), ebenfalls in der Wanne befindlich, und wenigstens eine dieser beiden Elektroden aus dem Metall hergestellt ist, das man abscheiden will, um eine Anode zu bilden,
b) Aufrechterhalten des Kontakts zwischen einer Seite des Substrats (9, 81) und der ersten Elektrode (5, 5'),
c) Anordnen - zwischen der dem Substrat (8, 91) entgegengesetzten Seite (18) und der zweiten Elektrode (7, 7') - eines Elements (13, 13'), hergestellt aus einem elektrisch isolierenden Material und eine Maske bildend, wobei diese Maske wenigstens eine Öffnung (15, 15') aufweist, die der Form der Beschichtung entspricht, die man auf besagtem Substrat reproduzieren will,
d) Verschieben dieser Maske (13, 13'), um sie mit Hilfe der Verstelleinrichtungen (17, 17') gegen besagte entgegengesetzte Seite (18) des Substrats (9, 81) zu pressen, so daß kein Elektrolyt zwischen der Maske (13, 13') und dem Substrat (9, 81) zurückbleibt.
e) Anlegen einer schwachen elektrischen Spannung zwischen der ersten (5, 5') und der zweiten Elektrode (7, 7'), um die Beschichtung herzustellen,
f) Abheben der Maske (13, 13') von dem beschichteten Substrat (9, 81) mit Hilfe der Verstelleinrichtungen (17, 17'),
g) halbkontinuierliches Weiterbewegen des schwach leitenden, biegsamen Substrats (9, 81) zwischen der ersten Elektrode (5, 5') und der Maske (13, 13') und Wiederholen der Schritte d) bis f) auf aufeinanderfolgenden Teilstücken des Substrats (9, 81).

12. Produkt, hergestellt nach Anspruch 11, dadurch gekennzeichnet, daß das Substrat (9) einen elektrisch isolierenden Textilträger (65) umfaßt, beschichtet mit einem dotierten, elektronisch leitenden organischen Polymer (67), und dadurch, daß das abgeschiedene Metall (69) wenigstens zwei Elektroden (71, 73) bildet.

13. Produkt, hergestellt durch das Verfahren nach Anspruch 12, dadurch gekennzeichnet, daß die beiden Elektroden (71, 73) die Form von Kämmen aufweisen, die einander derart gegenüberstehen, daß die Zähne der Elektrode (71) und die Zähne der Elektrode (73) ineinandergreifen.

14. Produkt, hergestellt durch das Verfahren nach Anspruch 11, dadurch gekennzeichnet, daß das Substrat (81) ein dotiertes, elektronisch leitendes organisches Polymer ist, und dadurch, daß das Metall auf zwei seitlichen entgegengesetzten Rändern des besagten Substrats abgeschieden wird, um einen kontinuierlichen Streifen (85) zu bilden, gegen den Mittelteil des Substrats (81) verlängert durch Elektroden (87).

15. Produkt nach Anspruch 14, dazu bestimmt, ein zur Herstellung eines Handschuhs verwendetes Heizelement (77) zu bilden, dadurch gekennzeichnet, daß das Metall auf jedem der entgegengesetzten Ränder des Substrats (81) so abgeschieden ist, daß es eine Elektrode (87) bildet, versehen mit einem elektrischen Verbindungsstreifen (85) und einer seitlichen Zunge (89).

## Claims

1. Apparatus for the electrolytic deposition of a metal on a weakly conductive, flexible substrate (9, 81), characterized in that it comprises an electrolytic cell (1), a first and a second planar electrodes (5,5'; 7,7') placed in said electrolytic cell and at least one element (13,13') forming a mask placed between the two electrodes (5,5'; 7,7'), said mask (13,13') being made from an electrically insulating material having at least one opening (15,15') with the shape of the deposit which it is wished to reproduce on said substrate (9, 81) and being provided with motor means (17,17') permitting the displacement thereof between a first position where it is remote from the substrate to be treated (9, 81) and a second position where it is engaged on said substrate (9, 81).

2. Electrolytic deposition apparatus according to claim 1, characterized in that the second electrode (7,7') is fixed to the mask (13,13') so as to form therewith a space (21,21') defined by spacing means (22,22').

3. Electrolytic deposition apparatus according to claim 2, characterized in that the spacing means (22) are formed by at least one sleeve (23) placed round at least one screw (25) fixing the second electrode (7) to the mask (13).

4. Electrolytic deposition apparatus according to claim 2, characterized in that the face (35) of the mask (13) positioned facing the second electrode (7') is hollowed out in its central portion (37) so as to define on its periphery a ledge (22') forming said spacing means.

5. Electrolytic deposition apparatus according to claim 1, characterized in that the second electrode (7') is fixed beneath a support block (39) made from an electrically insulating material and in that said support block (39) comprises at least one groove (41, 45) hollowed in its mass and connecting the upper face (43) of the second electrode (7') to the exterior, said second electrode (7') having at least one orifice (49) issuing into one of the said grooves (41) and in one of the said openings (15') of the mask (13'), so as to form a circuit for discharging the hydrogen formed during the electrolytic reaction.

6. Electrolytic deposition apparatus according to claim 1, characterized in that the motor means (17) are formed by at least one screw (19) and at least one bolt (20).

7. Electrolytic deposition apparatus according to claim 1, characterized in that the motor means (17') are formed by pneumatic jacks.

8. Electrolytic deposition apparatus according to claim 1, characterized in that the first electrode (5') is formed from a sheet (27) of electricity conducting material and a base (29) provided with compressed air means (31, 33) permitting the engagement of said sheet (27) with the substrate (9, 81).

9. Electrolytic deposition apparatus according to claims 1 or 8, characterized in that the dimensions of the first electrode (5') are equal to or greater than those of the mask (13') level with the periphery of said mask.

10. Electrolytic deposition apparatus according to claim 1, characterized in that the first electrode (5,5') is a cathode and the second electrode (7,7') an anode made from copper or nickel.

11. Process for the electrolytic deposition of a metal on a weakly conductive, flexible substrate (9, 81) in the form of a continuous strip, characterized in that it comprises the following stages:
a) immersing said substrate (9, 81) in an electrolytic cell (1) filled with an electrolyte (3), said weakly conductive, flexible substrate (9, 81) being positioned between the first and second electrodes (5,5'; 7,7') also placed in said electrolytic cell, at least one of the said two electrodes being made from the metal which it is wished to deposit and constituting an anode,
b) maintaining one face of said substrate (9, 81) in contact with said first electrode (5,5'),
c) placing between the opposite face (18) of said substrate (9, 81) and the second electrode (7,7'), an element (13,13') made from an electrically insulating material and forming a mask, said mask having at least one opening (15,15') corresponding to the shape of the deposit which it is wished to reproduce on said substrate,
d) moving said mask (13,13') in order to engage it against said opposite face (18) of the substrate (9, 81) by motor means (17,17'), so that there is no electrolyte (3) between the mask (13,13') and the substrate (9, 81),
e) applying a low voltage between the first (5,5') and second (7,7') electrodes so as to produce the deposit,
f) removing the mask (13,13') using said motor means (17,17') in order to obtain the substrate (9, 81) covered with the deposit,
g) passing the substrate (9,81) semicontinuously between the first electrode (5,5') and the mask (13,13') and repeating stages d) to f) on successive portions of said substrate (9, 81).

12. Product obtained by the process according to claim 11, characterized in that the substrate (9) comprises an electrically insulating, textile support (65) covered with a doped, electronically conductive, organic polymer (67) and in that the deposited metal (69) forms at least two electrodes (71, 73).

13. Product according to claim 12, characterized in that each of the two electrodes (71, 73) is shaped like a comb and are positioned facing one another in such a way that the teeth of the electrode (71) are engaged in the teeth of the electrode (73).

14. Product obtained by the process according to claim 11, characterized in that the substrate (81) is a doped, electronically conductive, organic polymer and that the metal is deposited on two opposite lateral edges of said substrate so as to form a continuous strip (85) continued towards the median portion of the substrate (81) by the electrodes (87).

15. Product according to claim 14 for forming a heating element (77) used in the manufacture of a glove, characterized in that the metal is deposited on each of the opposite edges of the substrate (81), so as to form an electrode (87) provided with an electrical connection strip (85) and a lateral tongue (89).
